# EUROPÄISCHE PATENTANMELDUNG

(11) **EP 2 594 397 A1**
(43) Veröffentlichungstag der Anmeldung: **22.05.2013**
(21) Anmeldenummer: 11189212.1
(22) Anmeldetag: 15.11.2011
(51) Int. Cl.: B32B 27/12, B32B 27/32, E04D 5/06

(54) **Membran mit Oberflächenstruktur**

(71) Anmelder: Sika Technology AG, 6340 Baar (CH)
(72) Erfinder: Hübscher, Peter, 6012 Obernau (CH); Rudolf, Jean-Claude, 6048 Horw (CH)
(74) Vertreter: Sika Patent Attorneys

(57) **Zusammenfassung**

Bei einer wasserdichte Membran umfassend eine Schottschicht aus thermoplastischem Material weist die Schottschicht auf der Oberseite einen arithmetischen Mittelrauwert Rₐ gemäss DIN EN ISO 4287: 1998-10 von 0.01 - 0.8 µm auf. Dadurch wird die Verschmutzungsneigung signifikant vermindert. Weiter lassen sich solche Membranen, insbesondere nach Lagerung bei erhöhten Temperaturen, leichter abrollen.

## Beschreibung

### Technisches Gebiet

Die Erfindung geht aus von einer Membran nach dem Oberbegriff des ersten Anspruches.

Die Erfindung geht weiter aus von einem Verfahren zur Abdichtung von Untergründen sowie einem Verfahren zur Erhöhung der Energieausbeute bei bi- oder multifacialen Photovoltaik-Elementen.

### Stand der Technik

Es ist bekannt, insbesondere für (Flach-)Dächer Sonnenlichtreflektierende Membranen einzusetzen, um eine allzu starke Erwärmung von Gebäuden zu verhindern. Durch das Reflektionsvermögen dieser Bedachungsmaterialien werden die Absorption der Sonnenstrahlung und die Umwandlung in Wärme verhindert. Neuerdings gibt es Photovoltaik-Systeme, sogenannte bi- oder multifacialen Photovoltaik-Elemente, bei welchen sich eine aktive Zelle auch auf der Rückseite findet, wodurch auch die vom Dach reflektierte elektromagnetische Strahlung in elektrische Energie umwandelt werden kann.

Es ist weiter bekannt, dass (Flach-)Dächer über die Nutzungsdauer verschmutzen. Dies kann beispielsweise während der Dachverlegung erfolgen oder über die Nutzungsdauer durch Partikel wie Russ, Humus, Sand sowie Laub hervorgerufen werden.

Solche Verschmutzungen führen nicht nur zu unansehnlichen Oberflächen, insbesondere bei weissen oder farbigen Oberflächen, sondern vermindern auch das Reflektionsvermögen dieser Bedachungsmaterialien.

### Darstellung der Erfindung

Aufgabe der vorliegenden Erfindung ist es daher, eine Membran der eingangs genannten Art dahingehend zu verbessern, dass die Verschmutzungsneigung solcher Membranen verringert wird. Erfindungsgemäss wird dies durch die Merkmale des ersten Anspruches erreicht.

Kern der Erfindung ist es also, dass eine wasserdichte Membran eine Schottschicht aufweist, wobei die Schottschicht ein thermoplastisches Material aufweist. Die Schottschicht weist auf der Oberseite einen arithmetischen Mittelrauwert Rₐ gemäss DIN EN ISO 4287: 1998-10 von 0.01 - 0.8 µm, auf.

Solche Membranen haben den Vorteil, dass sie eine verminderte Verschmutzungsneigung aufweisen und sich leichter reinigen lassen. Weiter wird dadurch die Kraft, welche benötigt wird, um solche Membranen im aufgerollten Zustand wieder abzurollen, insbesondere nach Lagerung bei Temperaturen über 60°C, signifikant verringert.

Weitere vorteilhafte Ausgestaltungen der Erfindung ergeben sich aus den Unteransprüchen.

Weitere Aspekte der Erfindung sind Gegenstand weiterer unabhängiger Ansprüche.

### Kurze Beschreibung der Zeichnung

Im Folgenden werden anhand der Zeichnungen Ausführungsbeispiele der Erfindung näher erläutert. Gleiche Elemente sind in den verschiedenen Figuren mit den gleichen Bezugszeichen versehen.

Es zeigen:
Fig. 1, 2, 3 je einen Querschnitt durch eine erfindungsgemässe Membran,
Fig. 4 Bi- oder multifaciales Photovoltaik-Element angeordnet auf einer erfindungsgemässen Membran,
Fig. 5 Messungen Abrollkräfte nach Lagerung bei verschiedenen Temperaturen,
Fig. 6 Reflexionsmessungen Verschmutzungsversuch.

Es sind nur die für das unmittelbare Verständnis der Erfindung wesentlichen Elemente gezeigt.

### Weg zur Ausführung der Erfindung

In einem ersten Aspekt betrifft die vorliegende Erfindung eine wasserdichte Membran 1 umfassend eine Schottschicht 2, wobei die Schottschicht ein thermoplastisches Material aufweist, vorzugsweise thermoplastische Polyolefine oder Polyvinylchlorid (PVC), insbesondere Polypropylen (PP) oder Polyethylen (PE). Die Schottschicht 2 weist auf der Oberseite 3 einen arithmetischen Mittelrauwert Rₐ gemäss DIN EN ISO 4287: 1998-10 von 0.01 - 0.8 µm, insbesondere 0.025 - 0.5 µm, bevorzugt 0.05 - 0.2 µm, auf.

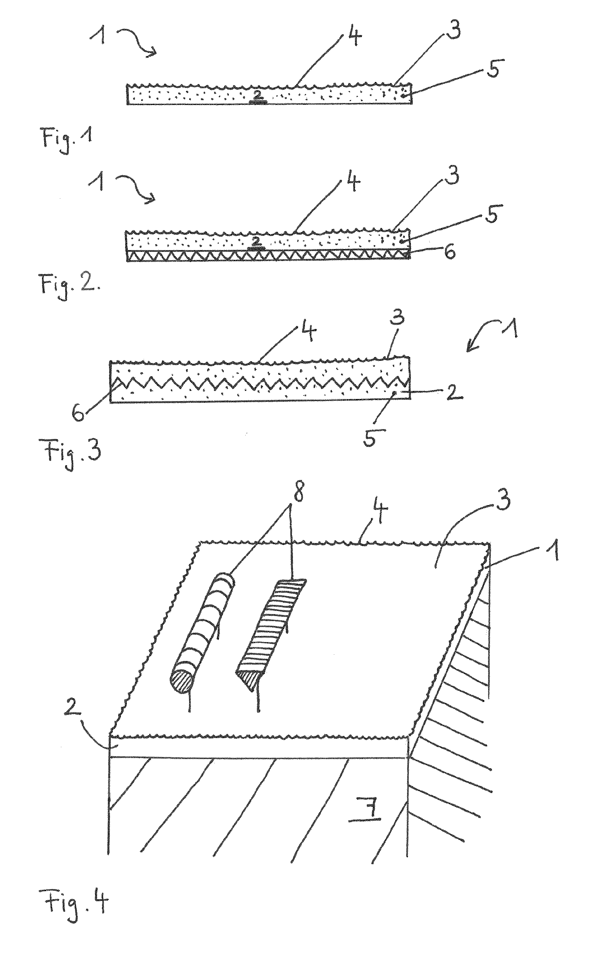

In der Figur 1 ist eine mögliche Membran 1 dargestellt.

Unter dem Begriff "Membran" werden in diesem Dokument insbesondere biegsame flächige Kunststoffe mit einer Dicke von 0.1 bis 5 mm, insbesondere 0.5 bis 4 mm, verstanden, die sich aufrollen lassen. Somit werden neben Folien im strengen Sinn von Dicken unter 1 mm, auch, und zwar vorzugsweise, Abdichtungsbahnen, wie sie typischerweise zum Abdichten von Dächern oder Terrassen in einer Dicke von typischerweise 1 bis 3 mm, in Spezialfällen sogar in einer Dicke bis maximal 5 mm, verwendet werden, verstanden. Derartige Membranen werden üblicherweise durch Streichen, Giessen, Kalandrieren oder Extrusion hergestellt und sind typischerweise in Rollen kommerziell erhältlich oder werden vor Ort hergestellt. Sie können einschichtig oder mehrschichtig aufgebaut sein. Es ist dem Fachmann klar, dass solche Membranen noch andere Zusatzstoffe und Verarbeitungsmittel, wie Füllstoffe, UV- und Hitzestabilisatoren, Weichmacher, Gleitmittel, Biozide, Flammschutzmittel und Antioxidantien enthalten können. Bei der erfindungsgemässen Membran 1 handelt es sich vorzugsweise um eine Dachmembran.

Die Membran weist vorzugsweise eine Dicke von 0.1 bis 5 mm, vorzugsweise von 0.5 bis 4 mm, insbesondere bevorzugt von 1 bis 3 mm, auf.

Die Schottschicht 2 weist auf der Oberseite 3 einen arithmetischen Mittelrauwert (arithmetischer Mittelwert der Profilordinaten) Rₐ gemäss DIN EN ISO 4287: 1998-10 von 0.01 - 0.8 µm, insbesondere 0.025 - 0.5 µm, auf. Vorzugsweise beträgt der arithmetische Mittelrauwert Rₐ gemäss DIN EN ISO 4287: 1998-100.05 - 0.2 µm.

Ein arithmetischer Mittelrauwert Rₐ gemäss DIN EN ISO 4287: 1998-10 von 0.01 - 0.8 µm ist dahingehend von Vorteil, dass dadurch die Verschmutzungsneigung signifikant vermindert wird. Weiter lassen sich solche Oberflächen leichter reinigen.

Weiter wird dadurch die Kraft, welche benötigt wird, um solche Membranen im aufgerollten Zustand wieder abzurollen, insbesondere nach Lagerung bei Temperaturen über 60°C, signifikant verringert gegenüber Membranen mit einem arithmetischen Mittelrauwert Rₐ gemäss DIN EN ISO 4287: 1998-10 von mehr als 0.8 µm, insbesondere von mehr als 3 µm.

Vorzugsweise weisen ≥ 50%, insbesondere ≥ 80%, insbesondere bevorzugt ≥ 98% der Gesamtfläche der Oberseite 3 einen vorgehend genannten arithmetischen Mittelrauwert Rₐ gemäss DIN EN ISO 4287: 1998-10 auf.

Vorzugsweise weist die Schottschicht 2 auf der Oberseite 3 ein Prägemuster 4 auf, welches zur vorgehend erwähnten arithmetischen Mittelrauwert Rₐ gemäss DIN EN ISO 4287: 1998-10 führt.

Bei dem Prägemuster 4 handelt es sich vorzugsweise um ein gleichmässiges Prägemuster.

Vorzugsweise weist die die Schottschicht 2 auf der Oberseite 3 eine Farbe auf, deren jeweiligen Anteile von Cyan, Magenta, Gelb und Schwarz im CMYK-Farbmodell nicht über 5% betragen. Am meisten bevorzugt handelt es sich bei der Farbe um Weiss. Vorzugsweise weist die gesamte Oberseite 3 die vorgehend genannte Farbe auf.

Insbesondere bei hellen Oberseite, insbesondere bei einer Farbe, deren jeweiligen Anteile von Cyan, Magenta, Gelb und Schwarz im CMYK-Farbmodell nicht über 5% beträgt, ist eine geringe Verschmutzungsneigung besonders vorteilhaft weil bei hellen Oberseiten Verschmutzungen als besonders störend wahrgenommen werden und/oder das Reflexionsvermögen von elektromagnetischer Strahlung, insbesondere Sonnenlicht, reduziert wird.

Es kann weiter vorteilhaft sein, wenn die Schottschicht 2 Pigmente 5 aufweist, wobei der Anteil der Pigmente 1 - 40 Gewichts-%, vorzugsweise 10 - 30 Gewichts-%, bezogen auf das Gesamtgewicht der Schottschicht, beträgt.

Weiter kann es vorteilhaft sein, wenn die Pigmente einen SRI (Solar Reflectance Index gemäss ASTM E 1980) von ≥ 70, insbesondere ≥ 78, aufweisen.

Vorzugsweise sind die Pigmente ausgewählt aus der Gruppe bestehend aus Bariumsulfat, Zinkoxid, Magnesiumoxid, Zirkuniumoxid und Titaniumoxid, insbesondere Titaniumoxid.

Durch das Vorhandensein von Pigmenten 5 in der Schottschicht 2 wird elektromagnetische Strahlung des Sonnenlichts stärker von der Membran reflektiert, womit sich beispielsweise die Energieausbeute bei bi- oder multifacialen Photovoltaik-Elementen erhöht und/oder die absorbierte Menge an Wärmeenergie vom Bauwerken vermindert. Weiter ist dadurch die Verminderung der Verschmutzungsvermögen von grösserer Wichtigkeit.

Die wasserdichte Membran 1 umfasst eine Schottschicht 2. Die Schottschicht besteht typischerweise aus Materialien, welche auch bei hohen Flüssigkeitsdrücken eine ausreichende Dichtheit gewährleisten.

Es ist also von Vorteil, wenn die Schottschicht 2 eine hohe Beständigkeit gegen Wasserdruck und Witterung aufweist, sowie gute Werte in Weiterreissversuchen und Perforationsversuchen zeigt, was besonders bei mechanischen Belastungen auf Baustellen von Vorteil ist. Weiter ist eine Beständigkeit gegenüber andauernden mechanischen Belastungen, beispielsweise Wind, vorteilhaft. Vorzugsweise handelt es sich bei dem Material der Schottschicht um ein flexibles Material.

Die Schottschicht weit ein thermoplastisches Material auf, vorzugsweise thermoplastische Polyolefine oder Polyvinylchlorid (PVC), insbesondere Polypropylen (PP) oder Polyethylen (PE). Daraus resultiert eine hohe Widerstandsfähigkeit gegenüber Umwelteinflüssen.

Vorzugsweise ist die Schottschicht 2 ausgewählt aus Materialien aus der Gruppe bestehend aus Polyethylen mit hoher Dichte (HDPE), Polyethylen mit mittlerer Dichte (MDPE), Polyethylen mit tiefer Dichte (LDPE), Polyethylen (PE), Polyvinylchlorid (PVC), Ethylen/Vinylacetat-Copolymer (EVA), chlorsulfoniertes Polyethylen, thermoplastische Elastomere auf Olefinbasis (TPE-0, TPO) und Polyisobutylen (PIB), sowie und Mischungen davon.

Vorzugsweise besteht die Schottschicht 2 zu 50 - 100 Gew.-%, insbesondere 80 - 90 Gew.-%, aus einem der vorgenannten Materialien, bezogen auf das Gesamtgewicht der Schottschicht.

Die Schottschicht 2 weist vorzugsweise eine Dicke von 0.1 - 5 mm, bevorzugt 0.5 - 2.5 mm, insbesondere 1 - 2 mm, auf.

Es ist weiter vorteilhaft, wenn die Dicke der Membran 1 20% - 100% der Dicke der Schottschicht 2 beträgt.

Vorzugsweise weist die Membran 1 einen Faserwerkstoff 6, insbesondere ein Gewebe, ein Gelege oder ein Vlies, auf. Der Faserwerkstoff kann beispielsweise an der Schottschicht angebracht sein, wie dies in Figur 2 ersichtlich ist, oder in die Schottschicht eingearbeitet sein, wie in Figur 3 gezeigt. Vorzugsweise ist in die Schottschicht 2 ein Faserwerkstoff 6, insbesondere ein Gewebe, ein Gelege oder ein Vlies, eingearbeitet.

Unter Faserwerkstoff ist im ganzen vorliegenden Dokument ein Werkstoff zu verstehen, welcher aus Fasern aufgebaut ist. Die Fasern umfassen oder bestehen aus organischem, anorganischem oder synthetischem Material. Insbesondere handelt es sich um Zellulose-, Baumwollfasern, Proteinfasern, Glasfasern oder um synthetische Fasern. Als synthetische Fasern sind vor allem bevorzugt Fasern aus Polyester oder aus einem Homo- oder Copolymeren von Ethylen und/oder Propylen oder aus Viskose zu nennen. Die Fasern können hierbei Kurzfasern oder Langfasern, gesponnene, gewebte oder ungewebte Fasern oder Filamente sein. Weiterhin können die Fasern gerichtete oder gestreckte Fasern sein.

Der aus Fasern aufgebaute Körper kann auf die verschiedensten dem Fachmann bekannten Verfahren hergestellt werden. Insbesondere kommen Körper zum Einsatz, die ein Gewebe, Gelege oder Gewirke sind.

Besonders bevorzugt als Faserwerkstoff ist ein Gewebe, Gelege oder Vlies. Weiter bevorzugt sind Faservverkstoffe, die eine Maschenzahl (oder Meshzahl) von 5 - 40 pro 10 cm aufweisen.

Es ist weiter von Vorteil, wenn der Faserwerkstoff 6 die Schottschicht 2 vor mechanischen Belastungen schützen kann. Insbesondere beim Verlegen und Anbringen der wasserdichten Membran 1 kann es zu starken mechanischen Belastungen kommen, beispielsweise bei Begehung der wasserdichten Membran. Es ist daher vorteilhaft, wenn der Faserwerkstoff 6 ein gewisses Flächengewicht aufweist und somit eine gewisse Druckwiderstandsfähigkeit gegen mechanische Belastungen aufweist. Insbesondere geeignet sind Faservverkstoffe, insbesondere Gewebe, Gelege oder Vliese, mit einem Flächengewicht von 30 - 200, insbesondere von 50-1150 g_{/}m²_{.}

Vorteilhafterweise besteht der Faserwerkstoff 6 aus einem thermoplastischen Material und das Material ist ausgewählt aus der Gruppe umfassend Polyethylen mit hoher Dichte (HDPE), Polyethylenterephthalat (PET), Polystyrol (PS), Polypropylen (PP), Polyvinylchlorid (PVC), Polyamid (PA) und Kombinationen davon.

Es kann weiter vorteilhaft sein, wenn der der Faserwerkstoff 6 aus einem anorganischen Material, insbesondere aus Glas, besteht.

In einem weiteren Aspekt betrifft die Erfindung die Verwendung einer wasserdichten Membran 1, wie sie vorgehend beschrieben ist, zur Erhöhung der Sonnenlichtreflexion von Bauwerken, insbesondere Gebäudedächern.

In einem weiteren Aspekt betrifft die Erfindung die Verwendung einer wasserdichten Membran 1, wie sie vorgehend beschrieben ist, zur Erhöhung der Energieausbeute bei bi- oder multifacialen Photovoltaik-Elementen 8.

Die Energieausbeute wird bei bi- oder multifacialen Photovoltaik-Elementen 8 dadurch erhöht, dass bei erfindungsgemässer Verwendung der Membran der Anteil an elektromagnetischer Strahlung, welcher von der Membran kommend auf das Photovoltaik-Element trifft, bezogen auf die Gesamtmenge an elektromagnetischer Strahlung, welche auf die Membran trifft, prozentual höher ist als bei Membranen des Standes der Technik. Die Quelle der elektromagnetischen Strahlung, welche auf die Membran trifft, ist typischerweise die Sonne. Die von der erfindungsgemässen Membran kommende elektromagnetische Strahlung umfasst typischerweise reflektierte elektromagnetische Strahlung.

In einem weiteren Aspekt betrifft die Erfindung ein Bauwerk, insbesondere ein Bauwerk des Hochbaus, bevorzugt ein Gebäude oder einen Platz, umfassend eine wasserdichte Membran 1, wie sie vorgehend beschreiben wurde. Vorzugsweise ist die Membran 1 auf dem Dach des Bauwerks angebracht. Weiter ist es vorteilhaft, wenn sich auf der Membran bioder multifaciale Photovoltaik-Elemente 8 befinden.

In einem weiteren Aspekt betrifft die Erfindung ein Verfahren zur Abdichtung von Untergründen 7 umfassend die Schritte:
i) Applizieren einer wasserdichten Membran, wie sie vorgehend beschrieben wurde, an einen Untergrund 7, wobei die Oberseite 3 der wasserdichten Membran 1 entgegen dem Untergrund 7 gerichtet ist.

Vorzugweise weist das Verfahren zusätzlich den Schritt ii) anbringen von mindestens einem bi- oder multifacialen Photovoltaik-Element 8 auf der Oberseite 3 der wasserdichten Membran 1, auf.

Vorzugsweise wird die Membran in einem Abstand von 20 - 200 cm von mindestens einem bi- oder multifacialen Photovoltaik-Element 8 auf einem Untergrund 7 angeordnet, auf welchem auch das mindestens eine bi- oder multifacialen Photovoltaik-Element angebracht ist.

Bei dem Untergrund 7 handelt es sich typischerweise um ein Bauwerk wie ein Gebäude oder einen Platz. Vorzugsweise handelt es sich bei dem Untergrund 7 um einen Teil, insbesondere das Dach, von einem Bauwerk, insbesondere einem Gebäude.

Die Membran 1 kann auf jede Art und Weise hergestellt werden. Insbesondere können die Membranen auf handelsüblichen Maschinen hergestellt werden. Die Membranen können in einem einzigen Verfahrensschritt als Endlosware, beispielsweise durch Extrusion und/oder Kalandrieren und/oder Laminieren und/oder Kaschieren, hergestellt werden und beispielsweise auf Rollen aufgerollt werden. Die Massetemperatur im Extruder oder Kalander kann in einem Bereich von 120°C - 250°C, bevorzugt 130°C - 220°C insbesondere 180°C - 220°C, liegen, bevorzugt während der Extrusion und/oder dem Kalandrieren und/oder dem Laminieren und/oder dem Kaschieren.

Damit die Schottschicht auf der Oberseite einen arithmetischen Mittelrauwert Rₐ gemäss DIN EN ISO 4287: 1998-10 von 0.01 - 0.8 µm, insbesondere 0.025 - 0.5 µm, aufweist, kann beispielsweise eine Prägewalze verwendet werden.

Im Folgenden wird eine mögliche vorteilhafte Ausführungsform einer erfindungsgemässen Membran 1 beschrieben. Diese Membran 1, welche als Abdichtungsbahn ausgestaltet ist, besteht aus einer Schottschicht 2 aus thermoplastischen Polyolefinen. Die Schottschicht hat eine Dicke von 2 mm. Die Oberseite der Schottschicht weist einen arithmetischen Mittelrauwert Rₐ gemäss DIN EN ISO 4287: 1998-10 von 0.1 µm auf.

Im Folgenden wurde die Verschmutzungsneigung sowie die zum Abwickeln von einer Rolle benötigte Kraft zwischen einer erfindungsgemässen Membran (E) mit einer Schottschicht-Oberseite mit einem arithmetischen Mittelrauwert Rₐ gemäss DIN EN ISO 4287: 1998-10 von 0.1 µm und einer nicht-erfindungsgemässen Membran **(*V)*** mit einer Schottschicht-Oberseite mit einem arithmetischen Mittelrauwert Rₐ gemäss DIN EN ISO 4287: 1998-10 von 3 µm verglichen. Beide Membranen hatten eine Dicke von 2 mm und die Schottschichten bestanden aus thermoplastischen Olefinen.

Die Reflexionseigenschaften der beiden Membranen ***E*** und ***V*** wurden mit einem Solyndra Albedometer Model H 500 gemessen (Vor Versuch), danach wurden beiden Membranen E und V über einen Zeitraum von 45 Tagen mit Strassenschuhen betreten und die Reflexionseigenschaften wurden erneut bestimmt (Ungereinigt nach Versuch). Danach wurden die beiden Membranen ***E*** und ***V*** mit einfachen Reinigungsmitteln (feuchter Schwamm mit etwas kommerziellem Abwaschmittel) gereinigt und die

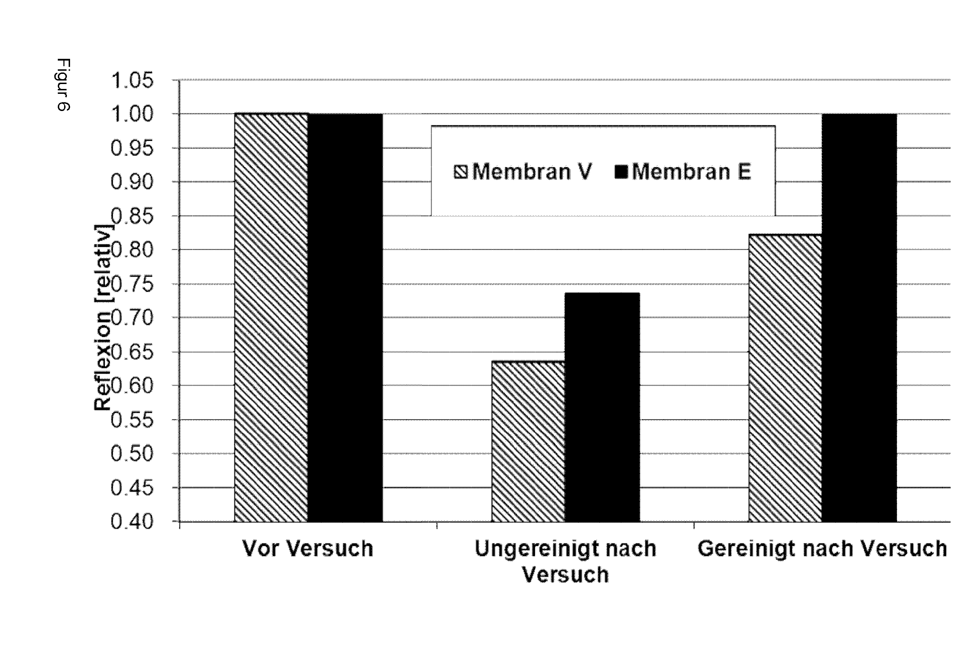

Reflexionseigenschaften erneut bestimmt (Gereinigt nach Versuch). Es ist aus Figur 6 ersichtlich, dass die erfindungsgemässe Membran (E) mit einer Schottschicht mit einem arithmetischen Mittelrauwert Rₐ gemäss DIN EN ISO 4287: 1998-10 von 0.1 µm weniger stark verschmutzt und sich leichter reinigen lässt als die nicht-erfindungsgemässe Membran *(**V**)* mit einem arithmetischen Mittelrauwert Rₐ gemäss DIN EN ISO 4287: 1998-10 von 3 µm.

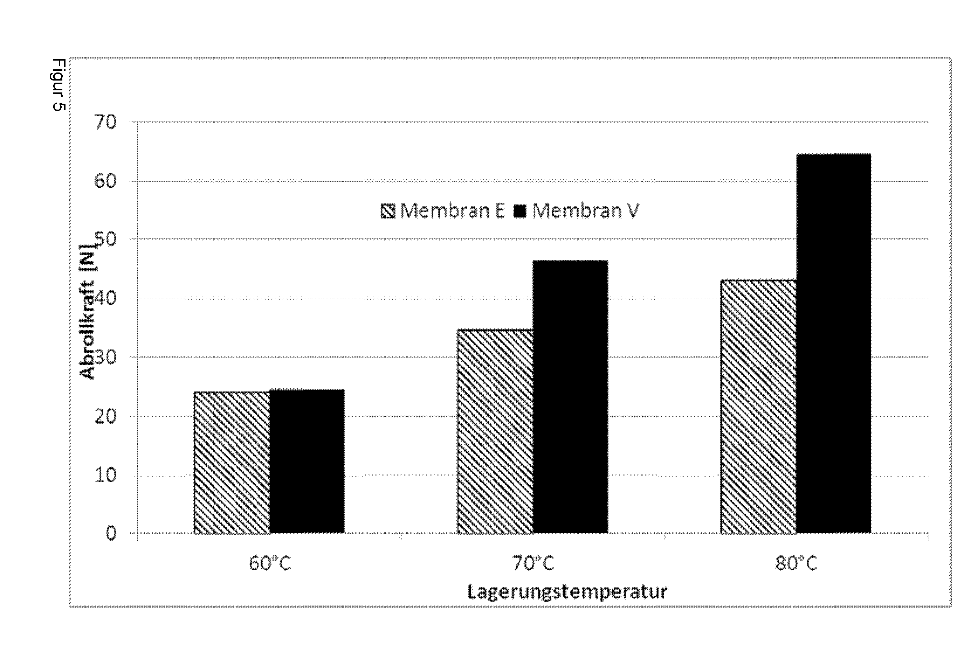

Rollen von einer Länge von 15 m und einer Breite von 25 cm der beiden Membranen ***E*** und ***V*** wurden in einem Trockenschrank während 24 h bei 60 °C, 70 °C oder 80 °C gelagert, nachfolgend wurden die beiden Membranen während 24 h bei 23 °C gelagert. Diese Rollen wurden anschliessend über eine Abzugseinrichtung mit Zugsmessdose abgerollt und die Höhe der Abrollkraft (take-off tension) gemessen. Die Lagerung im Trockenschrank bei verschiedenen Temperaturen erfolgte um das Verhalten der Membranen bei verschiedenen Lager-/Transportbedingungen zu bestimmen. Wie in Figur 5 ersichtlich, zeigen die erfindungsgemässen Membranen ***E***, insbesondere bei Lagerungstemperaturen über 60°C, überraschenderweise bedeutend tiefere Werte der benötigten Abrollkraft.

Selbstverständlich ist die Erfindung nicht auf die gezeigten und beschriebenen Ausführungsbeispiele beschränkt.

### Bezugszeichenliste

- 1: Wasserdichte Membran
- 2: Schottschicht
- 3: Oberseite der Schottschicht
- 4: Prägemuster
- 5: Pigmente
- 6: Faserwerkstoff
- 7: Untergrund
- 8: Bi- oder multifaciales Photovoltaik-Element

## Patentansprüche

1. Wasserdichte Membran (1) umfassend eine Schottschicht (2), wobei die Schottschicht ein thermoplastisches Material aufweist, vorzugsweise thermoplastische Polyolefine oder Polyvinylchlorid (PVC), und die Schottschicht (2) auf der Oberseite (3) einen arithmetischen Mittelrauwert Rₐ gemäss DIN EN ISO 4287: 1998-10 von 0.01 - 0.8 µm, insbesondere 0.025 - 0.5 µm, aufweist.

2. Wasserdichte Membran (1) gemäss Anspruch 1, **dadurch gekennzeichnet, dass** die Schottschicht (2) auf der Oberseite (3) ein Prägemuster (4) aufweist, welches zum erwähnten arithmetischen Mittelrauwert Rₐ gemäss DIN EN ISO 4287: 1998-10 führt.

3. Wasserdichte Membran (1) gemäss Anspruch 1 oder 2, **dadurch gekennzeichnet, dass** die Schottschicht (2) auf der Oberseite (3) eine Farbe aufweist, deren jeweiligen Anteile von Cyan, Magenta, Gelb und Schwarz im CMYK-Farbmodell nicht über 5% betragen.

4. Wasserdichte Membran (1) gemäss einem der vorhergehenden Ansprüche, **dadurch gekennzeichnet, dass** die Schottschicht (2) Pigmente (5) aufweist, wobei der Anteil der Pigmente (5) 1 - 40 Gewichts-%, vorzugsweise 10 - 30 Gewichts-%, bezogen auf das Gesamtgewicht der Schottschicht (2), beträgt.

5. Wasserdichte Membran (1) gemäss Anspruch 4, **dadurch gekennzeichnet, dass** die Pigmente ausgewählt sind aus der Gruppe bestehend aus Bariumsulfat, Zinkoxid, Magnesiumoxid, Zirkuniumoxid und Titaniumoxid, insbesondere Titaniumoxid.

6. Wasserdichte Membran (1) gemäss einem der vorhergehenden Ansprüche, dass die Dicke der Membran (1) 20 - 100 % der Dicke der Schottschicht (2) beträgt.

7. Wasserdichte Membran (1) gemäss einem der vorhergehenden Ansprüche, **dadurch gekennzeichnet, dass** die Schottschicht (2) eine Dicke von 0.1 - 5 mm, bevorzugt 0.5 - 2.5 mm, insbesondere 1 - 2 mm, aufweist.

8. Wasserdichte Membran (1) gemäss einem der vorhergehenden Ansprüche, **dadurch gekennzeichnet, dass** die Membran (1) eine Dicke von 0.1 bis 5 mm, vorzugsweise von 0.5 bis 4 mm, insbesondere bevorzugt von 1 bis 3 mm, aufweist.

9. Wasserdichte Membran (1) gemäss einem der vorhergehenden Ansprüche, **dadurch gekennzeichnet, dass** die Membran (1) einen Faserwerkstoff (6), insbesondere ein Gewebe, ein Gelege oder ein Vlies, aufweist.

10. Verfahren zur Abdichtung von Untergründen (7) umfassend die Schritte:
i) Applizieren einer wasserdichten Membran (1) nach einem der Ansprüche 1 - 9 an einen Untergrund (7), wobei die Oberseite (3) der wasserdichten Membran (1) entgegen dem Untergrund (7) gerichtet ist,

11. Verfahren gemäss Anspruch 10, **dadurch gekennzeichnet, dass** es sich bei dem Untergrund um einen Teil, insbesondere das Dach, von einem Bauwerk, insbesondere einem Gebäude, handelt.

12. Bauwerk umfassend eine wasserdichte Membran (1) nach einem der Ansprüche 1-9.

13. Verwendung einer wasserdichten Membran (1) nach einem der Ansprüche 1 - 9 zur Erhöhung der Sonnenlichtreflexion von Bauwerken, insbesondere Gebäudedächern.

14. Verwendung einer wasserdichten Membran (1) nach einem der Ansprüche 1 - 9 zur Erhöhung der Energieausbeute bei bi- oder multifacialen Photovoltaik-Elementen (8).
